Europäisches Patentamt

European Patent Office

Office européen des brevets

(11) Publication number: **0 530 440 A1**

# EUROPEAN PATENT APPLICATION

(21) Application number: **92107989.3**

(22) Date of filing: **12.05.92**

(51) Int. Cl.⁵: **C30B 25/00**, C30B 29/62, C30B 29/16

(30) Priority: **02.09.91 JP 246452/91**
**02.09.91 JP 246462/91**

(43) Date of publication of application:
**10.03.93 Bulletin 93/10**

(84) Designated Contracting States:
**CH DE FR GB LI NL**

(71) Applicant: **INTERNATIONAL SOFTWARE CORP.**
**15-17, Koishikawa 1-chome, Bunkyo-ku Tokyo(JP)**

(72) Inventor: **Nikkeshi, Susumu**
**14-1, Takanomori 3-chome, Tomiya-cho Kurokawa-gun, Miyagi-ken(JP)**
Inventor: **Yamamoto, Keiko**
**1-2, Takanomori 1-chome, Tomiya-cho Kurokawa-gun, Miyagi-ken(JP)**

(74) Representative: **Kraus, Walter, Dr. et al**
**Patentanwälte Kraus, Weisert & Partner Thomas-Wimmer-Ring 15 W-8000 München 22 (DE)**

(54) **Copper oxide whiskers and process for producing the same.**

(57) Novel copper oxide whiskers each consisting of a copper oxide single crystal can be obtained by heating metallic copper at a temperature of 250-700°c in an oxygen-containing atmosphere.

Copper oxide whiskers can be efficiently obtained by heating metallic copper at a temperature not lower than the melting point and then heating it at 250-700°C in an oxygen containing atmosphere.

Copper oxide whiskers can also be efficiently obtained by heating, in an oxygen-containing atmosphere, an alloy which is a uniform mixture of metallic copper and at least one element of the group IIIb of periodic table.

EP 0 530 440 A1

The present invention relates to copper oxide whiskers which can be used as a filler or reinforcing agent for plastics or in various other applications, as well as to a process for producing the whiskers.

Metal oxides take forms such as plate, acicular crystals, block and the like. Some metal oxides form whiskers.

Known metal oxides capable of forming whiskers are aluminum oxide, beryllium oxide, zinc oxide, magnesium oxide and the like. The whiskers of these metal oxides have respective forms and are considered to be promising as a filler for plastics, but they have not been satisfactory because of high cost and much labor required for production.

Thus, whiskers of various metal oxides are known. However, it has not been known that copper oxide forms whiskers.

An object of the present invention is to provide novel copper oxide whiskers.

Another object of the present invention is to provide economical copper oxide whiskers by using inexpensive metallic copper as a starting material.

Still another object of the present invention is to provide a process for efficiently producing copper oxide whiskers by a relatively simple method.

As a first aspect, the present invention provides copper oxide whiskers each consisting of a copper oxide single crystal. It has been unknown that copper oxide takes a form of whiskers. However, the present inventors have found that copper oxide forms whiskers each consisting of a single crystal, by heating metallic copper in an oxygen-containing atmosphere.

As a second aspect, the present invention provides a process for producing copper oxide whiskers, which comprises heating metallic copper at a temperature of 250-700°C in an oxygen-containing atmosphere to form whiskers of a copper oxide single crystal on the metallic copper surface. The oxygen-containing atmosphere may be nearly 100 % oxygen, a mixed gas (e.g. air) of oxygen and nitrogen or other gas, or a mixed gas of oxygen and nitrogen or other gas wherein the oxygen content is lower than in air, for example, several %. An atmosphere containing at least several % of oxygen can be used.

When the heating temperature is lower than 250°C, no whiskers are formed or, even if whiskers are formed, the amount is very small or the whiskers are very thin. Such a temperature is therefore undesirable.

When the heating temperature is higher than 700°C, whiskers are formed in a molten state. Such a temperature is therefore undesirable.

Metallic copper is heated in the above atmosphere at the above temperature for 0.5-30 hours.

The oxygen concentration in the atmosphere is presumed to have an effect on the rate of whisker formation, but can be at least 5 % economically although the reason is not clear yet. In an atmosphere containing at least 5 % of oxygen, whiskers of the present invention can be formed efficiently at the above heating temperature.

The present inventors have found that when metallic copper is melted before heating in an oxygen-containing atmosphere, copper oxide whiskers can be obtained more efficiently.

Hence, as a third aspect, the present invention provides a process for producing copper oxide whiskers, which comprises heating metallic copper at a temperature not lower than the melting point and then heating it at a temperature of 250-700°C in an oxygen-containing atmosphere. The oxygen-containing atmosphere can be the same as mentioned in the second aspect.

The melted copper may be cooled to room temperature and then heated at a temperature of 250-700°C. In this case, it is advantageous to powderize the cooled copper by a mechanical means such as file, grinder or the like because a larger surface area and consequently a higher yield are obtained. Alternatively, the melted copper may be cooled to 250-700°C and heated at that temperature in an oxygen-containing atmosphere. In this case, since copper oxide whiskers are formed on the surface of the metallic copper, separation of the whiskers from the unreacted copper oxide is easy. Thus, either of the above approaches can be adopted depending upon the purpose. Incidentally, the melting of the metallic oxide is preferably conducted in an inert atmosphere in order to prevent its oxidation.

According to the present invention, copper oxide whiskers can be produced efficiently by using, as a starting material, (a) copper obtained by a chemical reduction method (this copper is hereinafter referred to as chemical copper), for example, copper obtained by adding zinc to an aqueous copper sulfate solution to give rise to ion exchange and precipitation of reduced copper, or (b) so-called electrolytic copper obtained in the smelting step of copper. It has been known that when such chemical copper or electrolytic copper is merely heated at a temperature of 250-700°C in an oxygen-containing atmosphere, copper oxide whiskers are formed but the amount is very small. The present inventors have found that when chemical copper or electrolytic copper is melted and then heated as mentioned above, the amount of copper oxide whiskers formed is substantially larger. The reason is not made clear yet, but it is presumed that metallic copper, when melted and then cooled, has a dense crystal structure, enabling continuous supply of copper for

2

formation of copper oxide whiskers.

Preferably, the metallic copper used in the present invention contains substantially no impurity other than the metal elements (e.g. boron, aluminum, gallium, indium, thallium) of the group IIIb of periodic table, specifically such impurity in an amount smaller than 0.2 % by weight. When the element(s) other than the elements of the group IIIb is (are) contained, no copper oxide whiskers are formed or, even if they are formed, the amount is very small.

Needless to say, the element(s) other than the elements of the group IIIb excludes (exclude) elements which are vaporized in the smelting step of copper, such as hydrogen, helium, nitrogen, oxygen, fluorine, neon, argon, chlorine, bromine, cryptone and the like, and refers (refer) to semiconductors, semimetals and metals of the groups I, II, IIIa, IV, V, VI, VIIa and VIII which are presumed to remain in the smelting step of copper. When the metallic copper contains said element(s) other than the elements of the group IIIb in a total amount larger than 0.2 % by weight, the formation of copper oxide whiskers is difficult.

Meanwhile, the presence of the element(s) of the group IIIb gives no adverse effect or even a slightly better result.

Thus, as a fourth aspect, the present invention provides a process for producing copper oxide whiskers, which comprises heating, in an oxygen-containing atmosphere, an alloy which is a uniform mixture of metallic copper and at least one element of the group IIIb. It has been found that, although the reason is not made clear yet, copper oxide whiskers can be produced efficiently by heating an alloy of metallic copper and group IIIb element(s) in an oxygen-containing atmosphere.

As the group IIIb element(s), there are preferred one or more elements selected from boron, aluminum, gallium and indium, with aluminum being preferred particularly. The addition of metal(s) or element(s) other than the group IIIb elements to metallic copper is not preferable because it produces no copper oxide whiskers or produces a very small amount of copper oxide whiskers.

The amount of the group IIIb element(s) added to metallic copper is preferably 0.04-2.60 % by weight, particularly preferably 0.40-2.20 % by weight.

In actually producing copper oxide whiskers, copper and at least one group IIIb element are placed in a crucible and melted in a vacuum furnace, a muffle furnace, a high-frequency furnace, an arc furnace or the like to obtain a copper alloy. In this case, the copper and the at least one group IIIb element may be melted together, or, depending upon the structure of the furnace sued, the copper is melted first and then the at least one one group IIIb element is added to the molten copper. In any approach, the copper and the at least one group IIIb element must form an alloy wherein they are mixed uniformly.

The thus obtained alloy is mechanically shaven with a file, a grinder or the like to obtain a powder, or is melted and atomized by a so-called atomization method to obtain a powder.

The powder is heat-treated in an oxygen-containing atmosphere. The oxygen-containing atmosphere and heating conditions used can be the same as mentioned with respect to the aspect 2.

The present invention is hereinafter described in more detail by way of Examples.

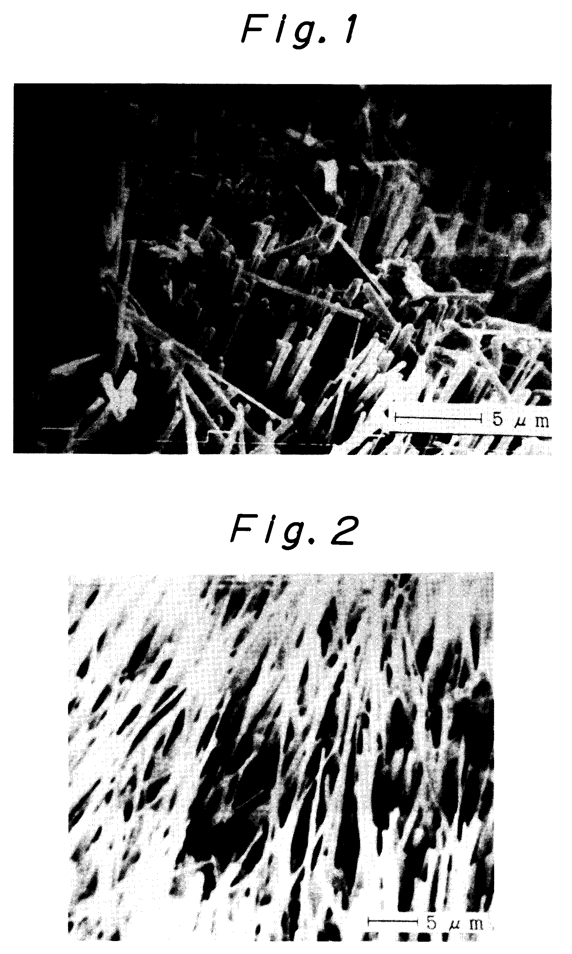

Figs. 1, 2 and 3 are the electron micrographs of the copper oxide whiskers obtained in Examples 1, 4 and 8, respectively.

Example 1

A copper bar of 1,200 mm x 10 mm (diameter) (a product of Sanpo Shindo Kogyo K.K.) having a purity of 99 % or more, obtained by subjecting a copper ingot to melting and extrusion, was shaven with a file to obtain 30 g of a copper powder. 10 mg of this copper powder was collected and heat-treated at 500°C for 2 hours in a differential thermal analyzer (TGD-7000, a product of Shinku Riko K.K.) used as an electric furnace, in an oxygen flow of 100 ml/min.

The powder after the treatment was observed using a scanning electron microscope (T-20, a product of Nihon Denshi K.K.), which confirmed the formation of whiskers as shown in Fig. 1. According to Fig. 1, the whiskers gave no polycrystalline sign and were recognized to be each a single crystal of copper oxide.

The whiskers each had a diameter of 0.2-0.6 μm and a length of 5-10 μm.

The amount of whiskers formed was found to be 34.4 % by weight, by weight calculation.

Example 2

The same procedure as in Example 1 was conducted except that oxygen was changed to oxygen-nitrogen mixed gases each of an oxygen/nitrogen ratio as shown in Table 1 or air, of flow rates shown in Table 1. The formation of whiskers was confirmed using an electron microscope. The results are shown in Table 1.

### Example 3

The same procedure as in Example 1 was conducted except that the heating temperature was changed to those shown in Table 2, whereby the formation of whiskers was examined. The results are shown in Table 2.

### Comparative Example 1

The same procedure as in Example 1 was conducted except that oxygen was changed to oxygen-nitrogen mixed gases of low oxygen concentration, as shown in Table 1. The results are shown in Table 1.

### Comparative Example 2

The same procedure as in Example 1 was conducted except that the heating temperature was changed to those shown in Table 2. The results are shown in Table 2.

## Table 1

### Conditions and results of Comparative Example 1 and Example 2

| | | $O_2 : N_2$ (Ratio in ml/min) | Formation of whiskers | Amount of whiskers formed (%) |
|---|---|---|---|---|
| Comparative Example 1 | | 1:99 | x | – |
| | | 2:98 | x | – |
| | | 3:97 | △ | Trace |
| | | 4:96 | △ | 0.02 |
| Example 2 | | 5:95 | o | 4.7 |
| | | 7:93 | o | 5.6 |
| | | 10:90 | o | 12.3 |
| | | 20:80 | o | 28.9 |
| | | 40:60 | o | 34.1 |
| | | 50:50 | o | 34.3 |
| | | 60:40 | o | 34.0 |
| | | 80:20 | o | 34.8 |
| | | 100:0 | o | 34.7 |
| | | Air | o | 29.0 |

x : Formation of whiskers could not be confirmed.

△ : Whisker are trace or they could not be clearly confirmed as whisker.

o : Formation of whiskers was clearly confirmed.

## Table 2
## Conditions and results of Comparative
## Example 2 and Example 3

| | | Temperature (°C) | Formation of whiskers | Amount of whiskers formed (%) |
|---|---|---|---|---|
| Comparative Example 2 | | 200 | x | − |
| | | 240 | x | − |
| | | 750 | x | − |
| | | 800 | x | − |
| Example 3 | | 250 | o | 3.7 |
| | | 650 | o | 33.1 |
| | | 700 | o | 29.9 |

Example 4

An electrolytic copper plate obtained by smelting of a black ore (a product of Kosaka Mine of Dowa Kogyo K.K.) was cut into square pieces each of about 1 cm x 1 cm with a pair of snips. The copper plate had a purity of 99.98 % according to a quality inspection. 20 g of the square pieces were placed in a crucible (TOP, SSA-H, C type); the crucible was fixed in a high-frequency furnace (MULTIHERTZ AURUM 05/0C made in Italy); and the copper was heated for 300 seconds while passing 20 l/min of argon gas as an inert atmosphere in the opening portion of the crucible, to melt the copper. The copper melted at 1,470°C. After visually confirming that the metallic copper in the crucible solidified, the crucible was allowed to stand in a room for cooling.

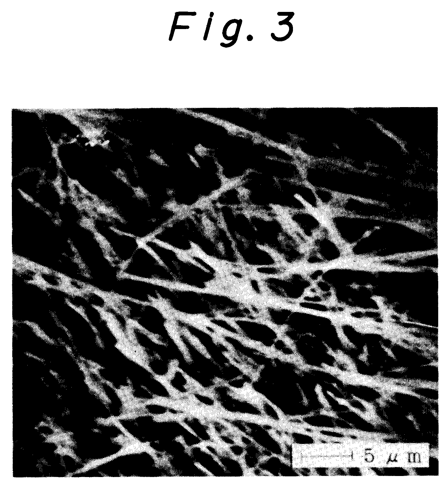

The crucible was broken and the copper lump was taken out. The lump was shaven with a file to obtain about 1 g of a copper powder. 5 mg of this copper powder was collected and heated at 550°C for 3 hours in a differential thermal analyzer (TGD-7000, a product of Shinku Riko K.K.) used as an electric furnace, in an oxygen flow of 80 ml/min. The copper after heating was observed using a scanning electron microscope (T-20, a product of NIhon Denshi K.K.), which clearly indicated formation of whiskers on the copper surface as shown in Fig. 2.

The whiskers each had a prismatic shape of 0.2-0.3 $\mu$m in one side and 3.0-4.0 $\mu$m in length. The amount of whiskers formed was found to be 38.8 % by weight, by weight calculation.

Example 5

The same procedure as in Example 4 was conducted except that the electrolytic copper plate was changed to an electrolytic copper powder (CE-115, a product of Fikuda Hakufun Kogyo K.K.). As a result, prismatic whiskers each of 0.2-0.3 $\mu$m in one side were obtained at a yield of 37.32 % by weight.

Comparative Example 3

The same procedure as in Example 4 was conducted except that the heating and melting of metallic copper was not conducted and the electrolytic copper plate itself was shaven with a file and the resulting powder was subjected to the same subsequent procedure. No copper oxide whiskers were formed.

Comparative Example 4

The same procedure as in Example 5 was conducted except that the electrolytic copper powder was heated in the same differential thermal analyzer as in Example 4 without being heated and melted. No copper oxide whiskers were formed.

## Example 6

About 50 g of copper sulfate (first class grade $CuSO_4$ $5H_2O$, a product of Wako Pure Chemical Industries, Ltd.) was dissolved in 300 ml of pure water. Thereto was added 20 g of granular zinc (first class grade, a product of Wako Pure Chemical Industries, Ltd.). The mixture was allowed to stand for 40 minutes at room temperature with occasional stirring, after which the granular zinc was separated from precipitated chemical copper by decantation. The color of copper sulfate was greenish blue and the remaining of unprecipitated copper ion was suspected, but washing, filtration and drying were conducted using a Toyo filter paper No. 5A to obtain 3 g of chemical copper.

The same procedure as in Example 4 was conducted except that 20 g of the electrolytic copper plate was changed to 1.5 g of the above chemical copper. Copper oxide whiskers each having a prismatic shape of 0.2-0.3 $\mu$m in one side and 2.5-5.0 $\mu$m in length were obtained at a yield of 35.1 % by weight.

## Comparative Example 5

The same procedure as in Comparative Example 4 was conducted except that there was used the chemical copper obtained in Example 6. No copper oxide whiskers were formed.

## Comparative Example 6

To the copper used in Example 4 was added one of the typical elements of the groups I, II, IIIa, IV, V, VI, VIIa and VIII of periodic table, shown in Table 3, in an amount corresponding to 1 % by weight. Each mixture was subjected to the same procedure as in Example 4.

The results are shown in Table 3. No copper oxide whiskers were formed.

Table 3

| Composition and results of Comparative Example 6 | | | |
|---|---|---|---|
| Metallic copper (g) | Added element and amount (g) | | Formation of whiskers | Amount of whiskers formed (% by wt.) |
| 19.8 | Beryllium | 0.2 | x | - |
| 19.8 | Magnesium | 0.2 | x | - |
| 19.8 | Yttrium | 0.2 | x | - |
| 19.8 | Titanium | 0.2 | x | - |
| 19.8 | Zirconium | 0.2 | x | - |
| 19.8 | Niobium | 0.2 | x | - |
| 19.8 | Tantalum | 0.2 | x | - |
| 19.8 | Chromium | 0.2 | x | - |
| 19.8 | Molybdenum | 0.2 | x | - |
| 19.8 | Manganese | 0.2 | x | - |
| 19.8 | Iron | 0.2 | x | - |
| 19.8 | Nickel | 0.2 | x | - |
| 19.8 | Silver | 0.2 | △ | Trace |
| 19.8 | Gold | 0.2 | x | - |
| 19.8 | Zinc | 0.2 | x | - |
| 19.8 | Cadmium | 0.2 | x | - |
| 19.8 | Tin | 0.2 | x | - |
| 19.8 | Lead | 0.2 | x | - |
| 19.8 | Bismuth | 0.2 | △ | Trace |
| 19.8 | Selenium | 0.2 | x | - |
| x : Formation of whiskers could not be confirmed. △ : Fine whiskers were formed but they could not be clearly confirmed as whiskers. | | | | |

Example 7

The same procedure as in Example 4 was conducted except that the electrolytic copper plate used in Example 4 was changed to various copper alloys which were each a uniform mixture of 19.8 g of the electrolytic copper plate used in Example 4 and zinc (first class grade, a product of Wako Pure Chemical Industries, Ltd.) of an amount shown in Table 4. The formation of whiskers and its amount were examined for each alloy. The results are shown in Table 4.

Table 4

| Amounts of zinc added and results of Example 7 | | | |
|---|---|---|---|
| No. | Amount of zinc added (% by weight) | Formation of whiskers | Amount of whiskers formed (% by weight) |
| 1 | 0.002 | o | 34.4 |
| 2 | 0.004 | o | 34.2 |
| 3 | 0.006 | o | 34.4 |
| 4 | 0.008 | o | 34.3 |
| 5 | 0.010 | o | 34.0 |
| 6 | 0.020 | o | 31.1 |
| 7 | 0.040 | o | 31.2 |
| 8 | 0.060 | o | 21.0 |
| 9 | 0.080 | o | 9.7 |
| 10 | 0.10 | o | 9.9 |
| 11 | 0.20 | o | 1.9 |
| 12 | 0.40 | △ | Trace |
| 13 | 0.60 | △ | Trace |
| 14 | 0.80 | x | - |
| 15 | 1.0 | x | - |
| 16 | 2.0 | x | - |
| 17 | 4.0 | x | - |
| x : Formation of whiskers could not be confirmed. △ : Fine whiskers were formed but they could not be clearly confirmed as whiskers. o : Whiskers were formed clearly. | | | |

Example 8

An electrolytic copper plate obtained by smelting of black ore (a product of Kosaka Mine of Dowa Kogyo K.K.) was cut into square pieces each of about 1 cm x 1 cm with a pair of snips. 19.8 g of these copper square pieces were placed in a crucible (TOP, SSA-H, C type) together with 0.2 g of an aluminum powder obtained by shaving a metallic aluminum bar (a commercial aluminum bar used for model making, of 8 mm in diameter and about 1 m in length). The crucible was fixed in a high-frequency electric furnace (MULTIHERTZ AURUM 05/0C made in Italy). The crucible contents were heated and melted at 1,470°C for 300 seconds while passing argon gas as an inert atmosphere at a rate of 20 l/min in the opening portion of the crucible. After visually confirming that the copper alloy in the crucible solidified, the crucible was taken out and placed in water for thorough cooling. The crucible was broken and the inside alloy was taken out. The alloy was shaven with a file to obtain about 1.2 g of an alloy powder. 10 mg of this copper alloy powder was collected and heated at 550°C for 3 hours in a differential thermal analyzer (TGD-7000, a product of Shinku Riko K.K.) used as an electric furnace, in an oxygen flow of 80 ml/min. The powder after heating was observed using a scanning electron microscope (T-20, a product of Nihon Denshi K.K.), which clearly indicated formation of whiskers as shown in Fig. 3.

The whiskers each had a diameter of 0.2 $\mu$m and a length of 2.0-5.0 $\mu$m. The amount of whiskers formed was found to be 52.8 % by weight, by weight calculation.

### Example 9

Copper oxide whiskers were formed in the same procedure as in Example 8 except that 0.2 g of the aluminum was changed to other group IIIb elements each of 0.2 g as shown in Table 5. The results are shown in Table 5.

Table 5

| Alloy compositions and results of Table 9 | | | | |
|---|---|---|---|---|
| Metallic copper (g) | Added element and amount (g) | | Formation of whiskers | Amount of whiskers formed (% by weight) |
| 19.8 | Boron | 0.2 | o | 52.7 |
| 19.8 | Gallium | 0.2 | o | 49.3 |
| 19.8 | Indium | 0.2 | o | 47.5 |

### Example 10

Copper oxide whiskers were formed in the same procedure as in Example 8 except that the aluminum was changed to combinations of group IIIb elements as shown in Table 6 to form various alloys.

The results are shown in Table 6.

Table 6

| Alloy compositions and results of Table 10 | | | | | |
|---|---|---|---|---|---|
| | Metallic copper (%) | Added elements and amounts (g) | | Formation of whiskers | Amount of whiskers formed (% by weight) |
| 1 | 19.8 | B:Al | 0.10:0.10 | o | 48.3 |
| 2 | 19.8 | B:Ga | 0.10:0.10 | o | 47.2 |
| 3 | 19.8 | B:In | 0.10:0.10 | o | 46.4 |
| 4 | 19.8 | Al:Ga | 0.10:0.10 | o | 47.5 |
| 5 | 19.8 | Al:In | 0.10:0.10 | o | 46.7 |
| 6 | 19.8 | Ga:In | 0.10:0.10 | o | 46.6 |
| 7 | 19.8 | B:Al:Ga | 0.06:0.06:0.07 | o | 47.1 |
| 8 | 19.8 | B:Al:In | 0.06:0.06:0.07 | o | 46.8 |
| 9 | 19.8 | B:Ga:In | 0.06:0.06:07 | o | 46.2 |
| 10 | 19.8 | Al:Ga:In | 0.06:0.06:0.07 | o | 46.5 |
| 11 | 19.8 | B:Al:Ga:In | 0.05:0.05:0.05 0.05 | o | 46.4 |

### Comparative Example 7

The same procedure as in Example 8 was conducted except that the aluminum was changed to 0.8 % of aluminum and 0.2 % of iron. No whiskers were formed.

As described above, the present invention enables efficient and reasonable production of novel copper oxide whiskers by a simple process.

The copper oxide whiskers of the present invention, as compared with conventional metal whiskers, are inexpensive and can be used as a filler or reinforcing agent for plastics.

Further, the copper oxide whiskers, being electroconductive, are very promising, for example, as a material for prevention of electromagnetic interference.

Furthermore, the copper oxide whiskers, having an excellent bactericidal action, are expected to be used in other applications.

## Claims

1. Copper oxide whiskers each consisting of a copper oxide single crystal.

2. A process for producing copper oxide whiskers, which comprises heating metallic copper at a temperature of 250-700°C in an oxygen-containing atmosphere to form whiskers of a copper oxide single crystal on the metallic copper.

3. A process for producing copper oxide whiskers, which comprises heating metallic copper at a temperature not lower than the melting point and then heating it at a temperature of 250-700°C in an oxygen-containing atmosphere.

4. The process set forth in Claim 3, wherein the metallic copper is electrolytic copper.

5. The process set forth in Claim 3, wherein the metallic copper is produced by a chemical method.

6. The process set forth in Claim 3, wherein the metallic copper contains substantially no impurities other than the elements of the group IIIb of periodic table.

7. The process set forth in Claim 3, wherein the metallic copper contains impurities other than the elements of the group IIIb in a total amount smaller than 0.2 % by weight.

8. A process for producing copper oxide whiskers, which comprises heating, in an oxygen-containing atmosphere, an alloy which is a uniform mixture of metallic copper and at least one element of the group IIIb of periodic table.

9. The process set forth in Claim 8, wherein the alloy contains at least one element of the group IIIb in an amount of 0.04-2.60 % by weight.

10. The process set forth in Claim 8, wherein the heating is made at a temperature of 250-700°C.

## Fig. 1

## Fig. 2

# Fig. 3

## DOCUMENTS CONSIDERED TO BE RELEVANT

| Category | Citation of document with indication, where appropriate, of relevant passages | Relevant to claim | CLASSIFICATION OF THE APPLICATION (Int. Cl.5) |
|---|---|---|---|
| X | JOURNAL OF CRYSTAL GROWTH. vol. 74, no. 3, April 1986, AMSTERDAM NL pages 469 - 479 KAITO ET AL 'Electron microscopic studies on structures and reduction process of copper oxide whiskers' * page 470 * --- | 1,2 | C30B25/00 C30B29/62 C30B29/16 |
| X | JOURNAL OF THE ELECTROCHEMICAL SOCIETY vol. 108, no. 2, February 1961, MANCHESTER, NEW HAMPSHIRE US pages 119 - 123 GULBRANSEN 'oxidation of copper between 250 C and 450 C and the growth of CuO whiskers' * page 121 * --- | 1,2 | |
| X | CHEMICAL ABSTRACTS, vol. 88, no. 10, 6 March 1978, Columbus, Ohio, US; abstract no. 66304a, INUI ET AL 'rate characteristics of oxidation-reduction of metallic catalysts...' page 261 ;column 1 ; * abstract * & NIPPON KAGAKU KAISHI vol. 12, 1977, KYOTO JP pages 1775 - 1779 ----- | 1,2 | TECHNICAL FIELDS SEARCHED (Int. Cl.5) C30B |

The present search report has been drawn up for all claims

| Place of search | Date of completion of the search | Examiner |
|---|---|---|
| THE HAGUE | 14 DECEMBER 1992 | COOK S.D. |

EPO FORM 1503 03.82 (P0401)